# EUROPEAN PATENT APPLICATION

(11) **EP 0 668 659 A2**
(43) Date of publication of application: **23.08.1995**
(21) Application number: 95301002.2
(22) Date of filing: 16.02.1995
(51) Int. Cl.: H03K 19/177

(54) **Reconfigurable ASIC**

(30) Priority: 17.02.1994 GB 9403030
(71) Applicant: Pilkington Germany (no. 2) Limited, St. Helens, Merseyside WA10 3TT (GB)
(72) Inventor: Austin, Kenneth, Northwich, Cheshire, CW9 8AL (GB)
(74) Representative: Cardwell, Stuart Martin

(57) **Abstract**

A configurable semi-conductor integrated circuit, with particular application as a re-configurable application specific device. In order to be able to rapidly switch between two or more, preferably several, configurations, the invention provides a configurable semi-conductor integrated circuit in which an area (1) thereof is formed with a plurality of cells (2) each having at least one function and interconnections with at least some other said cells (2). At least some of the plurality of cells have interconnections (25) which are electrically selectable as to their conduction state, and at least some of the plurality cells have interconnections (YA-YD) which are pre-wired. Each cell has two or more possible configurations, each configuration being defined by the cell function and/or its interconnection with other cells according to cell configuration data, and further comprising means (36, 38, 40) storing configuration data for at least two cell configurations (per cell) and means (30, 32, 34, 42, 48) to enable one of the possible cell configurations according to the cell configuration data selected.

## Description

The present invention relates to a configurable integrated circuit, with particular emphasis on a re-configurable application specific device but without limitation to same.

Micro-processors are designed into many applications because of their low cost and high performance. However, for many applications such as image compression and digital signal processing they are too slow. Modifications to the basic micro-processor architecture has led to several new devices, digital signal processors (DSP), reduced instruction set computers (RISC) and custom processors (CP). Each of these devices are optimised to perform a restricted number of tasks but at very high speed. Many applications require several types of such devices to achieve the necessary level of performance. This is because of the requirement to perform different types of computational tasks over a period of time or the limited capability of each device. Essentially these devices are used as low cost high performance numerical engines, each optimised to implement a general class of algorithms. However, a designer frequently requires a different architecture to efficiently implement a new algorithm and the usual practice in such circumstances is to design a custom processor for this task. This leads to long and expensive design cycles and does not allow the designer any flexibility to change the algorithm.

Field programmable gate arrays (FPGAs) are commonly used to replace standard products and they could be used as a numerical engine. However, they are general purpose devices that cannot efficiently implement high speed circuits. In order to achieve the level of complexity that is normally required, several FPGAs would be necessary which would increase the cost of the final system. Some FPGAs are configured using on chip static random access memory (SRAM) and these devices can be re-programmed to perform different tasks which could lead to greater flexibility and higher levels of performance. However, these devices are connected to an external source of configuration data that is accessed by the device to configure internal resources. The time to configure or re-configure the FPGA can be several milliseconds, due to the necessity to import configuration data from an external source, and this time is several orders of magnitude too slow. Reconfiguration speeds of less than 100 nano-seconds are required for high performance applications. As such FPGA's cannot be reconfigured fast enough to make them suitable for use as a high performance numerical engine. In FPGAs a considerable amount of silicon area is committed to the configuration memory which is required to program interconnect resources. Whilst in theory FPGA's could accommodate an additional configuration by increasing the amount of on chip memory which is available to hold configuration data this would probably increase the size of the chip by 60 per cent which would be prohibitive for high density arrays.

The aim of the invention is to provide a re-configurable architecture which can rapidly switch between two or more, preferably several, configurations. Another aim of this invention is to provide a device that is specifically optimised to carry out functions for numerically intensive applications. Another aim is to provide a device that prior to the application of power contains one or more boot up primary configurations, suitable for configuring the device into the intended application. A further aim is to produce a device that has provision for passing data between successive configurations of the (base) device. A still further aim is to ensure that during configuration of the device, data is held in a safe condition and that switching currents are minimised. A still further aim is to provide a configuration cache that will allow updating of configuration memories that are not currently in use. Another aim of the invention is to allow the device to select its own configuration from an external source of configuration data.

Another aim is to reduce the number of programmable interconnections by pre-wiring a portion of the logic into the required configuration.

A yet further aim is to increase performance of the device by pre-arranging specified primary functions to specific areas of the device such primary functions being substantially pre-wired.

Accordingly one aspect of the invention provides a configurable semi-conductor integrated circuit in which an area thereof is formed with a plurality of cells each having at least one function and interconnections with at least some other said cells, at least some of the plurality of cells having interconnections which are electrically selectable as to their conduction state, and at least some of the plurality of cells having interconnections which are pre-wired, each cell has two or more possible configurations, each configuration being defined by the cell function and/or its interconnection with other cells according to cell configuration data, and further comprising means storing configuration data for at least two cell configurations (per cell) and means to enable one of the possible cell configurations according to the cell configuration data selected.

By pre-wired in relation to interconnect we mean uninterruptable as to its conduction state. The configuration data controls selection of the cell function and/or cell interconnections preferably using decoders or alternatively controlled directly from memory. Thus for example the cells configuration data determines the routing of the signal through the cell. Direct connection paths exist between the configuration stores, the decoders and the selectable functions and interconnections. The term function as used herein may be a logic function, arithmetic function, or interconnect function. A cell may have one or more of these functions or a combination of two or more of these. Preferably the configuration data stores are disposed in the cell. The desired configuration is selected using an instruction bus receiving signals from a sequencer and controller. One or more of the configurations may be pre-wired (ie. not programmable). Advantageously one or more of the configuration data stores are programmable using a data transfer bus. Where more than one store is programmable an instruction update bus is provided to write enable the required configuration store. Configuration stores not currently accessed to control interconnection and/or cell function can be updated using the instruction update bus.

Since the present invention is particulary concerned with an application specific device which is optimised to perform a restricted number of tasks at high speed but which is quickly reconfigurable during program execution (when required) to perform some other specific task, cells are optimised for a primary function according to a primary configuration. Advantageously the primary configuration data is pre-wired. It is convenient to have two alternate pre-wired primary configurations. Cells can be and most usually will be optimised for different primary functions. Advantageously the pre-wired interconnections are used in connection with the optimised functions.

A possible primary function is that of an adder. Another aspect of the invention provides a multi-bit adder for summing at least two multi-bit words comprising a first multi-bit adder block for summing the least significant bits and at least one further multi-bit adder block for summing the most significant bits and having sum selection means wherein said further multi-bit adder block calculates the two possible sums resulting from a carry out from the previous block being equal to '0' and '1' respectively and wherein the sum selection means selects the sum of the further multi-bit adder block according to the carry out calculated from the previous block.

In the case of a Digital Signal Processor application, some cells will be optimised as Arithmetic Logic Units (ALU) while other cells may be optimised to carry out functions such as instruction decode or as processor registers. The number of different cells is only limited by the size of the array of cells. In practice the array will be divided into a number of discrete areas that are particularly efficient at implementing respective primary functions. It will be apparent that each of these cells has the capability to implement another function and usually a range of other functions according to other configurations. These additional functions are controlled by the controller and sequencer whose role is to ensure that the correct function is available when required. Primary functions may use general interconnect resources, but preferably they have their own dedicated resource for high speed connections between primary functions of other cells. In this way the performance of the device is not dependent on a general programmable interconnect resource and by connecting primary functions through resources with smaller parasitic loads, the device can operate faster.

In order to safeguard data when changing between configurations each cell has a latch controlled by a function control bit. Transient current is reduced when switching between configurations by the provision of a buffer in each cell, the buffer being controllable as to is state during reconfiguration by a control line.

It will be apparent that whilst this device has specific application in the field of numerical engines such as DSP's, the primary functions can be chosen to suit other applications. Accordingly the techniques can be applied to any application. For example, another application is as a programmable communications device.

Another aspect of the invention also provides a method of configuring a configurable semi-conductor integrated circuit in which a sequence is programmed with data to facilitate selection of a required configuration from at least two possibilities. Usually each of a plurality of cells will have at least two configuration possibilities. Advantageously the configurations are programmable and the method further comprises inputting and storing configuration data. A further advantageous feature is the ability to program the sequences to write over previously stored configuration data at a prescribed point in operation of the circuit. An aspect of the invention provides a semi-conductor integrated circuit in which the circuit configuration is changed according to a pre-programmed sequence of configuration during operation of the device.

The present invention will now be described by way of example only with reference to the accompanying drawings; in which:-
Figure 1 is a schematic layout for re-configurable application specific device embodying the invention;
Figures 2 and 3 illustrate diagrammatically the feature of the core architecture having different configurations and sequential access;
Figure 4 illustrates diagrammatically the feature of the core having cells which are optimised to implement specific functions;
Figure 5 illustrates diagrammatically a primary configuration for the device as a Digital Signal Processor (DSP);
Figure 6 illustrates diagrammatically a secondary configuration for the device as a large multiplier;
Figure 7 illustrates schematically the layout of a cell including configuration memory means;
Figure 8a illustrates diagrammatically the possible arrangement of the cells in blocks with optimised functions;
Figure 8b illustrates schematically programmable local and global interconnect resources for the cells;
Figures 9a and 9b illustrate diagrammatically how the global interconnect resources are connected to the cell input and output multiplexers;
Figures 9c and 9d illustrate diagrammatically an array of cell blocks and the arrangement of cells within a cell block;
Figure 10 illustrates diagrammatically cell output state control;
Figures 11, 12 and 13 illustrate diagrammatically three logic cell variants namely an Arithmetic Logic Unit function (ALU), an Accumulator function (ACC), and a Decode cell function respectively;
Figure 14 illustrates diagrammatically examples of different functions from the ALU and ACC optimised core cells;
Figure 15 illustrates diagrammatically details of configurable Static Random Access Memory provisions;
Figure 16 illustrates diagrammatically further details of the cell configuration memory;
Figure 17 illustrates diagrammatically instruction bus connections for DSP cells;
Figure 18 illustrates diagrammatically a novel parallel carry select adder architecture which can be configured by the device;
Figure 19 illustrates a cell configured to implement a single stage carry select adder;
Figure 20 illustrates a cell configured to implement two carry select adders;
Figure 21 illustrates an alternative cell configuration to implement a single stage carry select adder; and

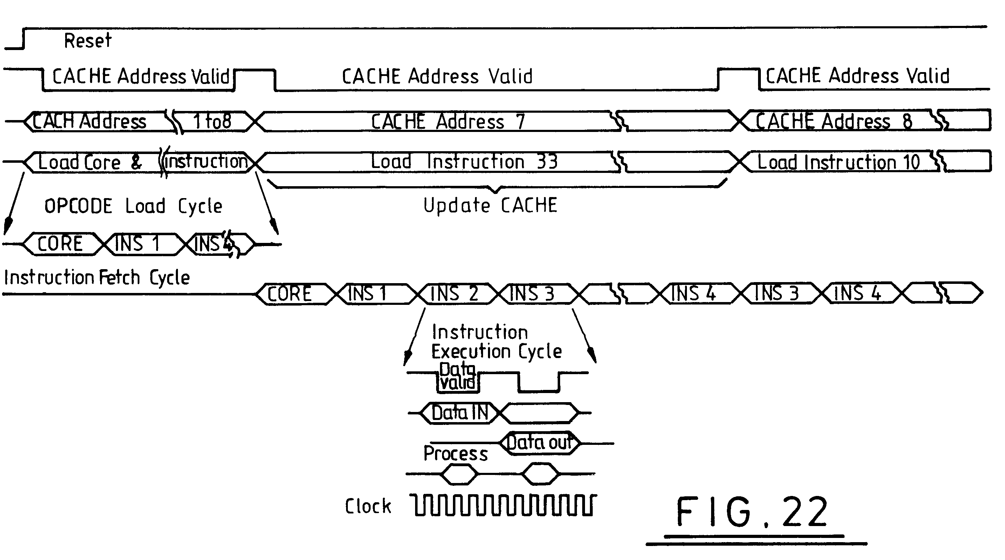

Figure 22 illustrates diagrammatically a DSP Timing Diagram.

The present invention is described in the context of an integrated circuit intended for an application specific device and will be described by way of example in the specific context of a Digital Signal Processor (DSP). According to the invention the device is not restricted to a fixed architecture, but has the hardware re-configurable to allow the device (eg. DSP) to be optimised for each individual task. Thus at a macro level the device may be optimised for a new application for example MPEG, Polygon Engine, Blitter, DMA Engine, whilst at a micro level, the device can be optimised for each OPCODE, eg. MULTIPLE ALU, CUSTOM MULTIPLY. Thus a re-configurable application specific device (eg. DSP) allows many custom devices to be replaced with a single chip. Optimised OPCODES increase performance. In effect the device can switch at clock speed between operating as a DSP, RISC or custom processor.

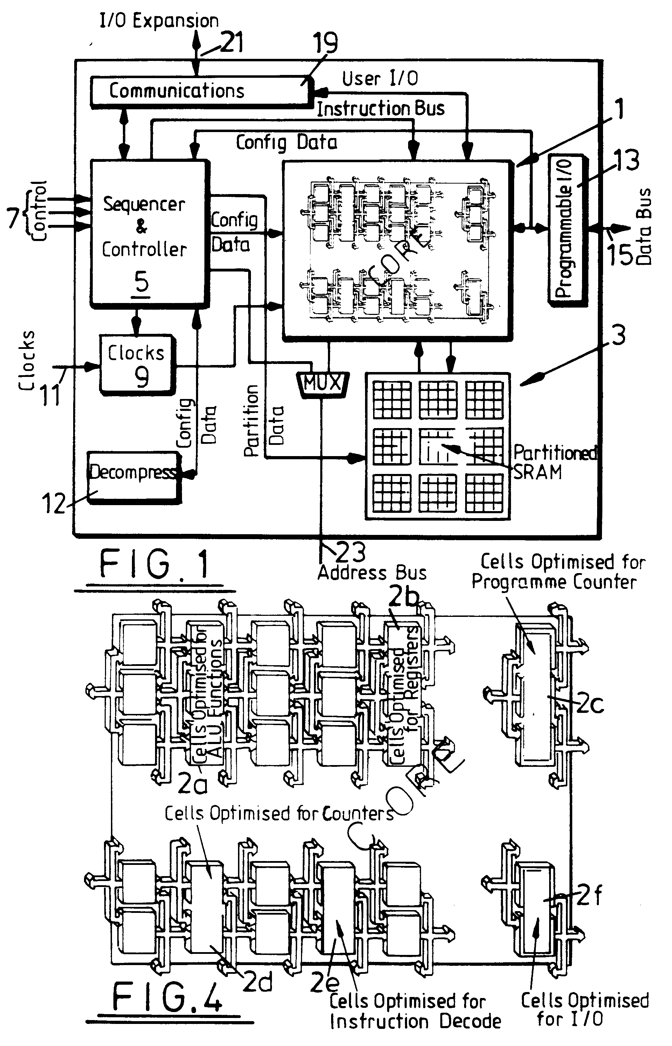

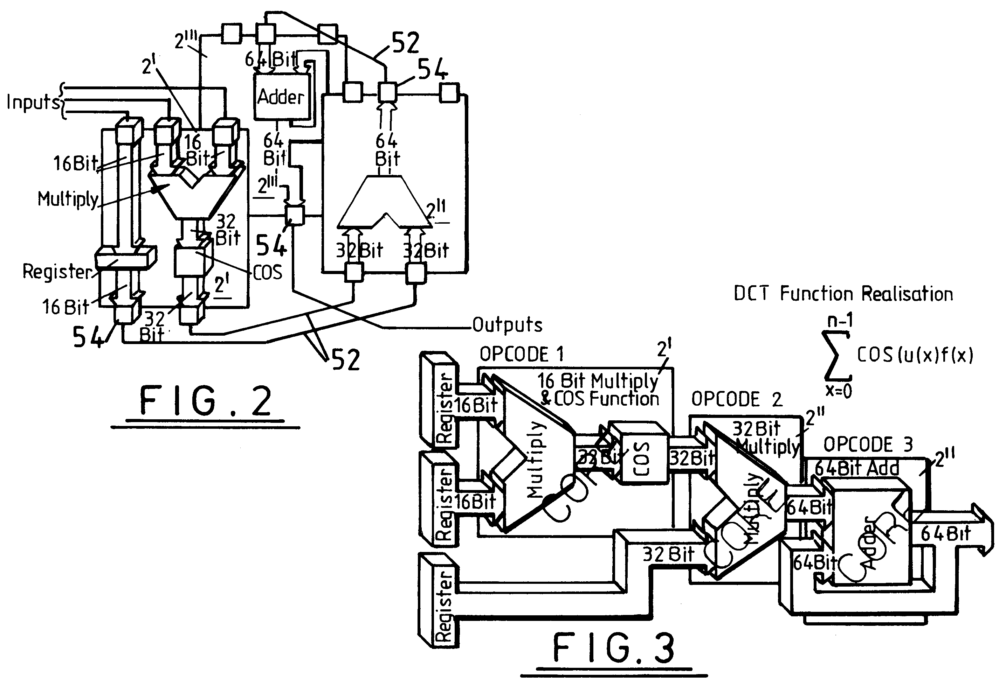

Referring firstly to Figure 1, here there is illustrated a re-configurable application specific digital signal processor. The chip includes an area 1 of core cells, Partitioned Static Random Access Memory (SRAM), 3, a sequencer and controller 5 having control lines 7, clocks 9 and clock lines 11, as well as programmable input/output 13 and associated data bus 15. Also shown is a signal Decompress decoder 17, a communications link 19 and associated input/output and Expansion porting 21, and address bus 23.

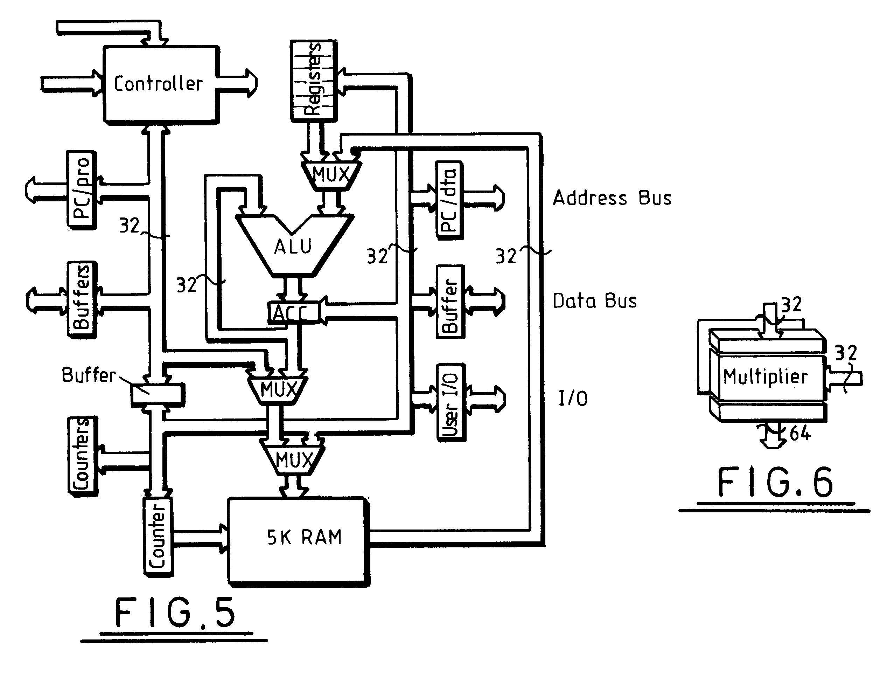

There are a plurality of core cells 2 and these provide for example (in the case of a DSP configuration), Instruction Decode, registers, programme counter and stack pointer facilities. Each core cell can be programmed to perform a range of functions and certain core cells are optimised to implement specific functions. Thus, for example, reference to Figure 4 illustrates optimisation of certain cells for ALU functions as at 2a, registers 2b, programme counter 2c, general counter 2d, instruction decode 2e and input/output 2f.

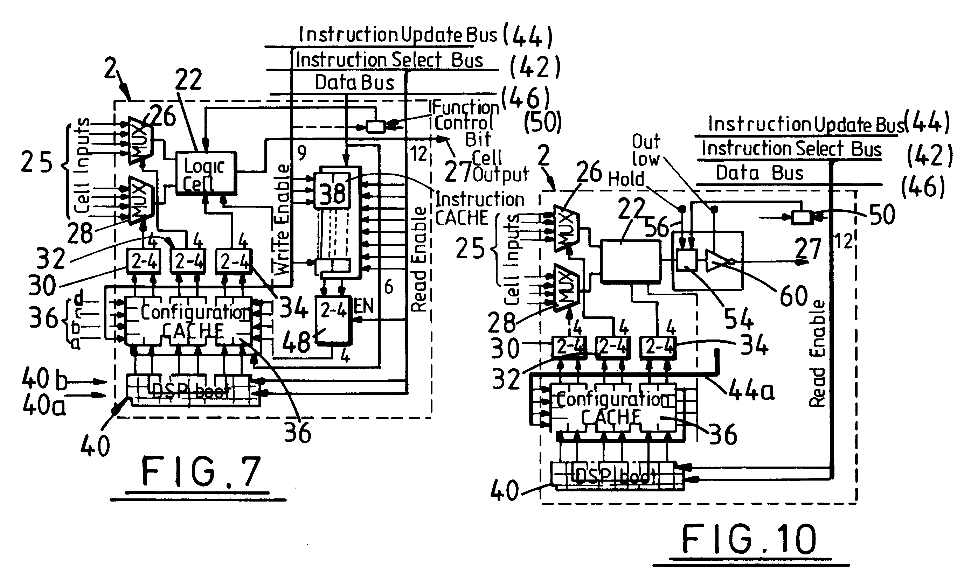

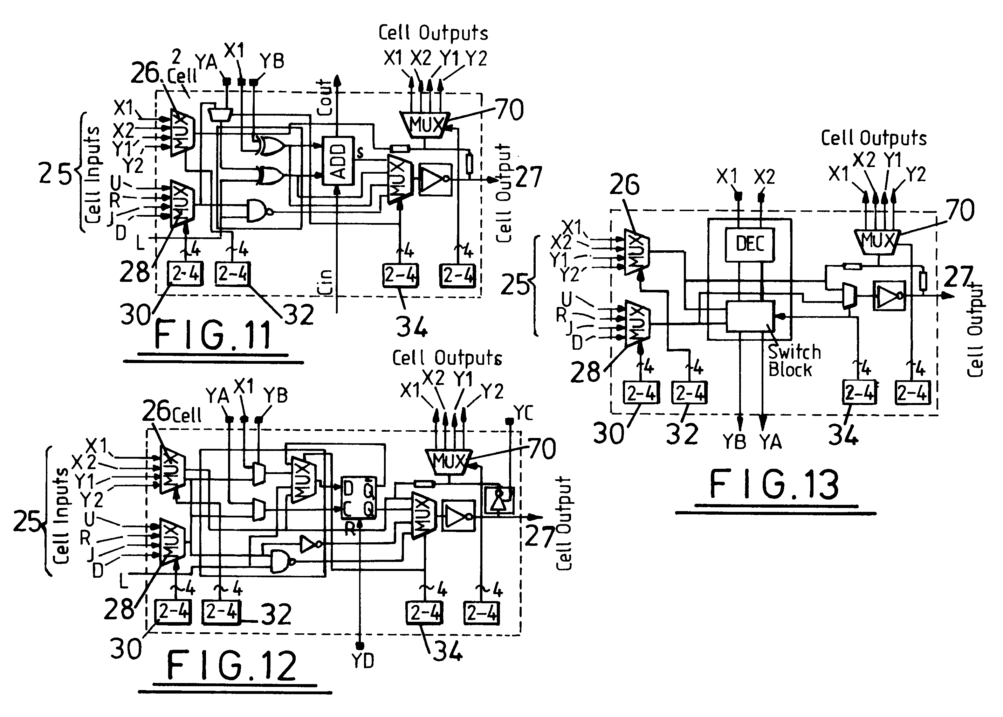

One schematic configuration of core cell denoted by dotted outline is shown in Figure 7 and the core cell includes within it a logic cell 22 having selectable functions (for example four). Programmable core cell inputs (eight) (ie. electrically selectable interconnections) are shown at 25 applied to two 4:1 input multiplexers 26,28. The cell output is shown at 27. Examples of Logic cell configurations are described further with reference to Figures 11, 12,13, and 14. Input multiplexers are controlled by respective 2-4 Decoders 30, 32. A further 2-4 Decoder 34, controls a 4-1 Multiplexer in the logic cell 22 and an output multiplexer 70 is controlled by a 2-4 Decoder 48. Direct pre-wired connections to the logic cell are indicated by numeral YA-YD.

In the Figure 7 illustration the cell includes configurable memory provisions comprising configuration cache 36 and instruction cache 38, as well as so called "hard wired" or fixed configuration provisions 40. For the DSP application the fixed configurations comprise a primary DSP Boot Configuration set by 3 x 2 bit configuration elements 40a, and a secondary configuration eg. Multiplier configuration set by 3 x 2 bit configuration elements 40b. It is intended that the primary (fixed) configuration will be implemented automatically on boot-up of the device so as to give it its primary application specific function.

The configuration cache 36 in the illustrated embodiment comprises four, 3 x 2 bit data stores, 36a-d which can be write enabled from an instruction update bus 44 and written with data from Data bus 46. The instruction cache 38 comprises 8 x 2 bit data stores which are write enabled from the Instruction update bus (44) and written with data from the data bus 46. The instruction cache 38 is read enabled from the Instruction select bus 42. A 2-4 Decoder 48 enabled from the instruction select bus 42 selects and read enables one of the four data stores 36a-d according to the data store of the instruction cache selected. The output of Decoder 48 also facilitates the direct configuration of the logic cell by controlling the 4:1 output multiplexer 70. Also illustrated is a function control bit 50 and has connections from the read and write enable lines (42,44) and into the logic cell 22. The function control bit 50 controls latch 54 (see Figure 10).

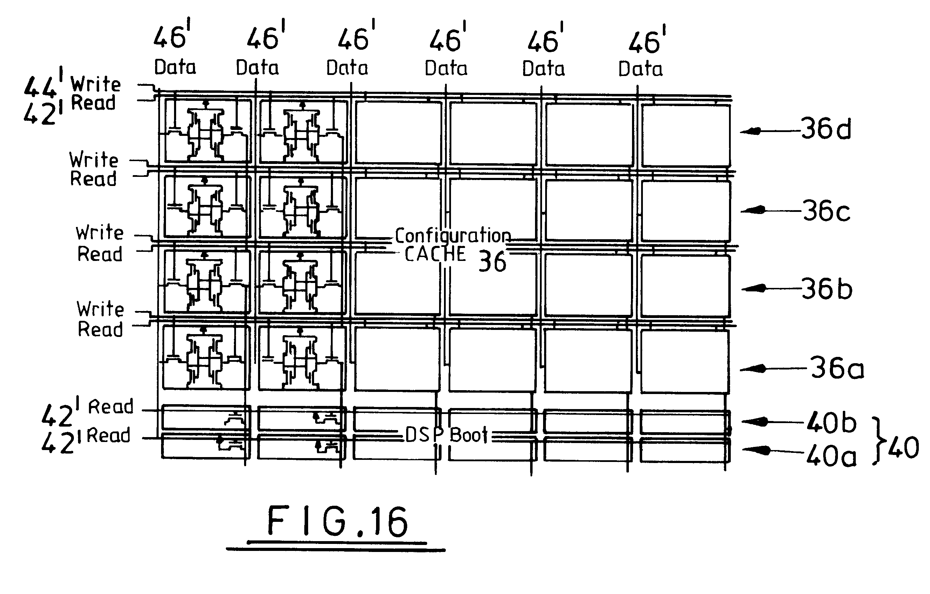

Figure 16 illustrates, for the fixed configuration provisions (40) and the configuration cache 36, the read (42), write 44' and data 46' connections. Note both read and write provisions for the configuration cache 36 only.

Reverting back to Figures 2 and 3, each of blocks 2', 2'' and 2''' represent configurations of the core 2. Large blocks of functionality are accessed as a series of configurations. Each new configuration receives data from the last using inter-process connections 52 and cells 54 designated for latching critical data. Other cells 54 are designated to act as inputs or outputs. Reconfiguration time can be of the order of 10nsec. The core architecture is optimised to implement each OPCODE. This allows the word size of each arithmetic function to be adjusted to the required provision. Thus, referring to Figure 3, a first core configuration (OPCODE 1) executes a 16 bit multiply and cos function, a second core configuration (OPCODE 2) carries out a 32 x 32 bit multiply function, and a third configuration (OPCODE 3) carries out a 64 bit ADD function.

Reference is now made to Figure 10 which illustrates the output state control as applicable to the like of the cell illustrated in Figure 7 and the corresponding cell components appropriately referenced are illustrated with the exception of the instruction cache 38.

As has been mentioned above certain cells are designated for latching critical data and hence the cells have a latch provision 54 with inputs from the function control bit 50 and a hold input line 56. These function to preserve the state of data from cells between configurations. In addition a buffer 60 is provided in order to reduce transient current when switching between configurations by setting its output state to a known condition.

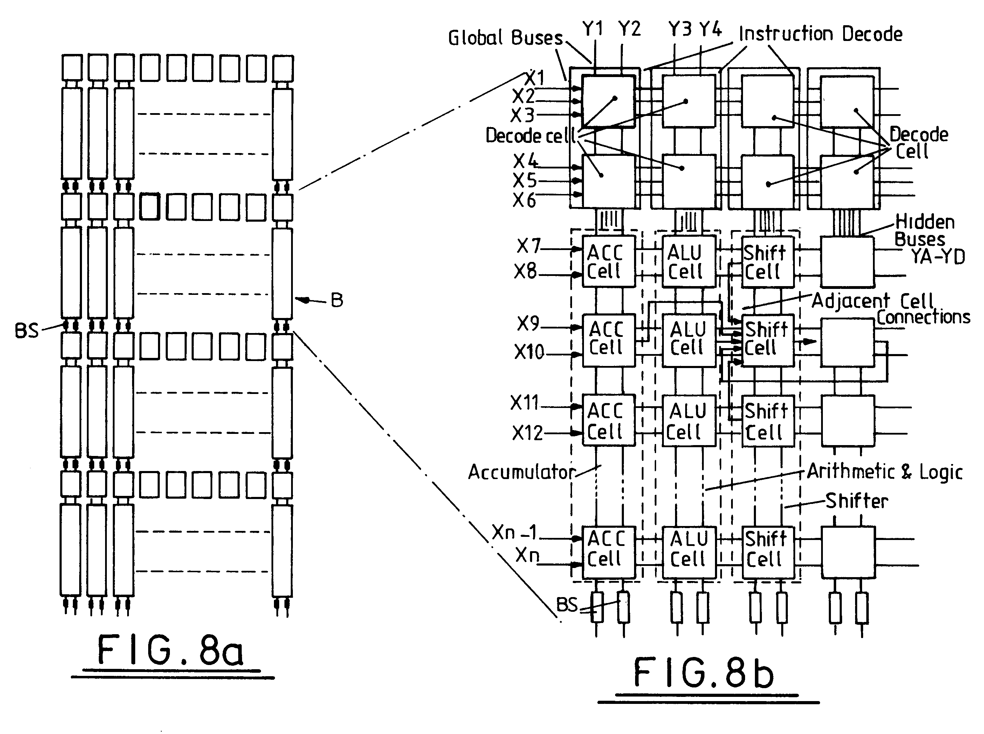

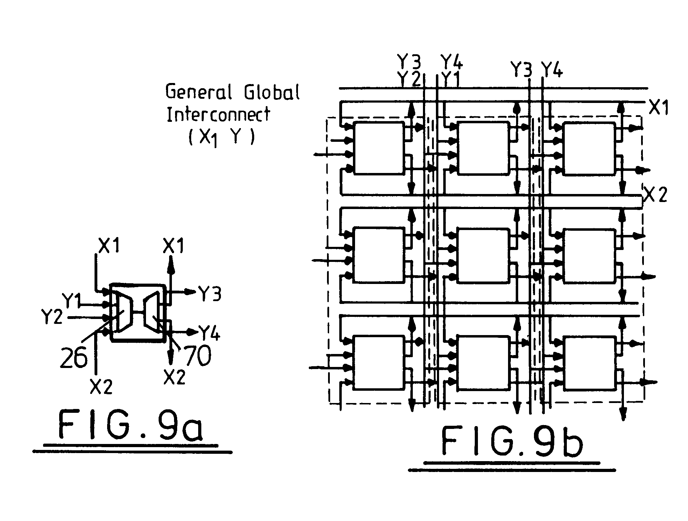

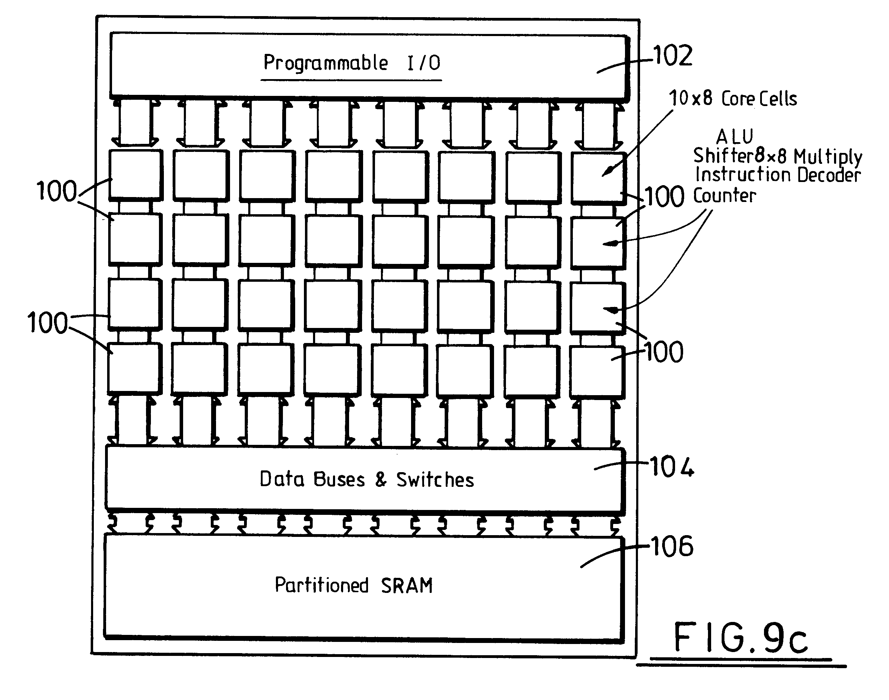

The cells interconnect resources are now described with reference to Figures 8a, 8b, 9a, and 9b. Figures 8a and 8b show diagrammatically how cells might be arranged in regular blocks (B) (eg. rows and columns), with the blocks including cells which are optimised for different functions. Thus Figure 8b shows columns of ACC cells, ALU cells and shift cells, and two rows of Decode cells. Columns of cells each have two global (Y) buses (Y1, Y2, Y3, Y4......YN1, YN) and the rows of cells each have at least two global (X) buses (X1, X2......Xn-1, Xn). The Decode cells head up the columns of each block and have three X buses. Bus switches BS are provided in the Y buses between adjacent blocks. In addition there are hidden (or pre-wired direct connection) Y buses, YA-YD. These run from the decode cells to all the cells in the column below. In addition local direct connection paths are preferred between cells. Thus, taking as an example cell SC in Figure 8b, it has input connections from outputs of an upper adjacent cell, a lower adjacent cell, a right adjacent cell, a left adjacent cell, and a next left adjacent cell. These connections are designated U, D, R, L, J. Not all cell variations will necessarily have all the local connections. The majority of these local connections are electrically selectable as to their conduction state, but most usually the left adjacent connection will be a pre-wired connection.

Figure 9a illustrates, for one cell as for all core cells, how an input multiplexer 26 controls selection of inputs from X and Y buses and an output multiplexer 70 controls selection of outputs to the same X buses and next column of Y buses.

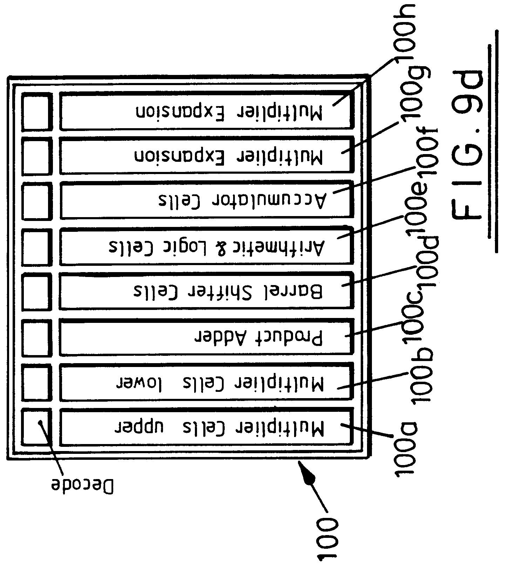

The cells are arranged in 10 x 8 blocks and an example of such an array of cell blocks is illustrated in Figure 9c. Blocks 100 are formed in an 8 x 4 array and a programmable input/output 102, data buses and switches 104 and partitioned SRAM 106 are also shown. Each block 100 comprises an array of 10 x 8 cells and conveniently, columns of cells within the block have a similar primary configuration. For example, Figure 9d illustrates a block 100 having two columns of cells 100 a & b configured as multiplexer cells, columns 100 c as a product adder, 100d barrel shifter cells, 100 e arthimetic and logic cells, 100 f accumulator cells and columns 100 g & h configured as multiplier expansion cells. The columns in each block are headed up by decode cells.

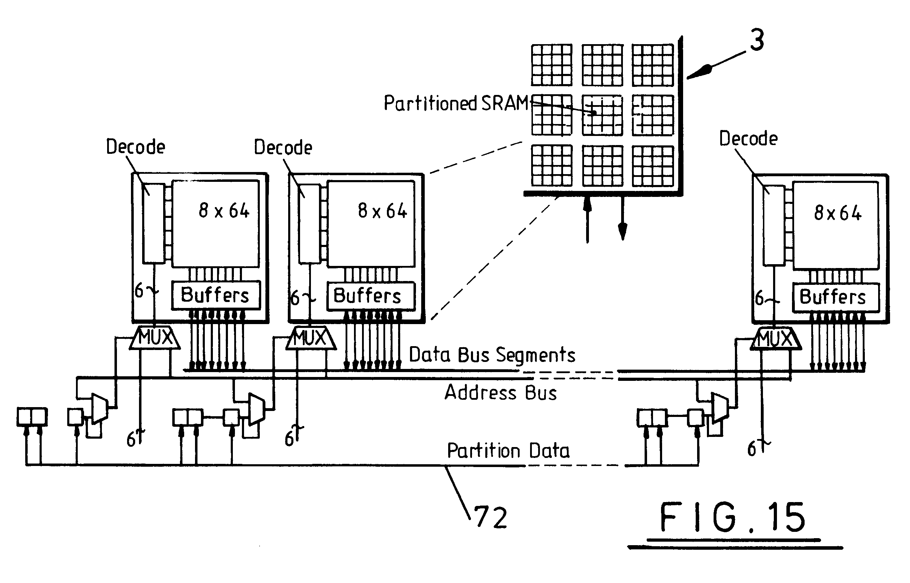

Referring now to Figure 15, the configurable static random access memory (SRAM) 3 stores partition data passed to it from the sequencer and controller 5 along partition data bus 72. The operation of the DSP requires the storing and retrieving of data and the provision of the SRAM on the device ensures that access to the stored data is faster than if the SRAM was located externally.

The sequencer and controller 5 controls the operation of buses 42, 44, 45 and 46. Hence, the sequencer and controller 5 includes the control of the operation of selecting individual data stores of cells, sending data to the stores and controlling the sequence of implementation of configuration data stored within cell. The necessary control instructions for the sequencer and controller 5 is provided by an external source of memory (not shown). In addition to the above operations, the controller 5 can select individual data stores not currently used such that they can be updated with new configurations from the external memory.

Figures 11, 12 and 13 illustrate respective ALU, ACC and Decode cell variants. Appropriate references have been used as previously referred to.

Figure 13 shows an example of a cell optimised for decode. Two decode cells will head up the blocks of cells as shown in Figures 8a and 8b. The illustrated variation is the one which has the pre-wired interconnection YA, YB which feed down to each of the cells below. The other decode will generate the YC, YD pre-wired interconnections. Thus the ALU type cells of Figure 11 have pre-wired connections YA, YB, whilst the ACC type cells have pre-wired connections YA, YB, YC, YD. Note also that for the ALU and ACC variants the left adjacent connection L is pre-wired, and for the ALU cell the Cin, Cout is a pre-wired interconnection running the length of the column of cells. Other X and Y buses are as described above.

Control signals from the outputs of the decode and for inputs of the cell variants will be pre-wired for the optimised cell functions, ie. for any functions which are known to be needed for the specific application.

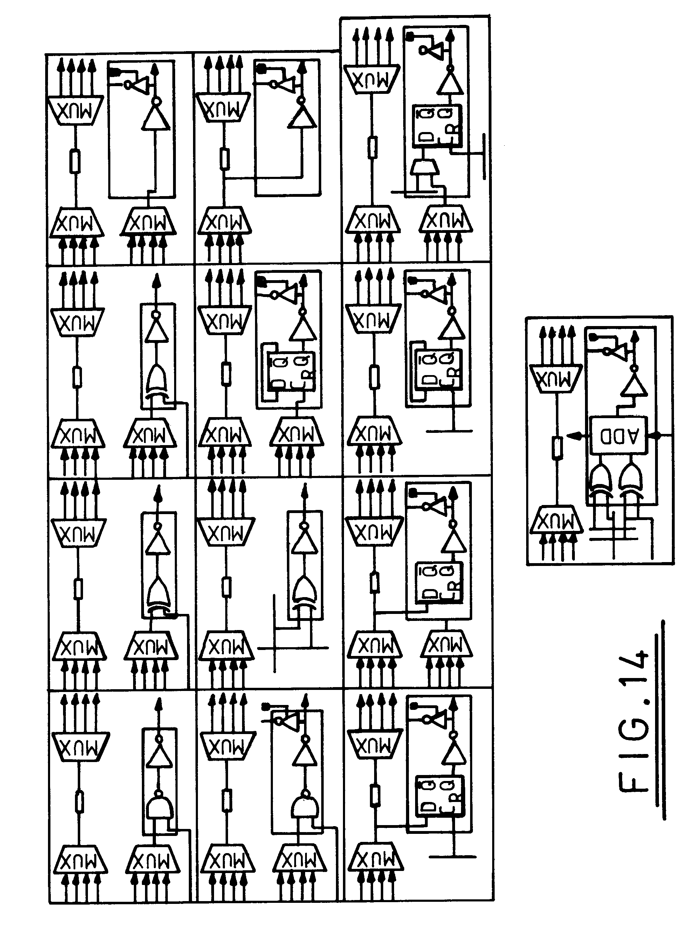

Figure 14 illustrates some of the different functions which are available from the ACC and ALU core cells of Figures 10 and 11 respectively.

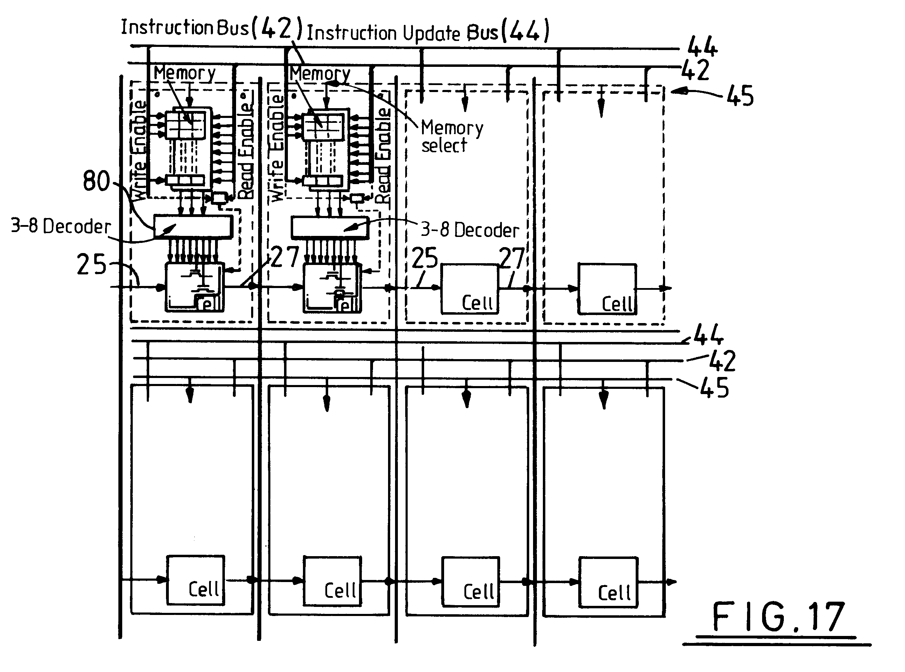

Figure 17 illustrates an alternative internal cell arrangement for the case of DSP cells (shown simplified) with the cell input shown simply at 25 and cell output at 27. The memory comprises 8 x 3 bit data stores and a 3-8 Decoder 80 is provided such that one of the eight selectable options (eg. functions or interconnect) contained in the logic cell can be selected. In order to update a particular data store within a particular cell there is provided a memory select 45 (omitted from the illustrations of the previously described cell arrangement) and hence the required cell can be selected and the particular data store to be write enabled or read enabled is selected by the instruction update bus (44) or instruction bus (42). Data is written to the data store from memory data bus (46) (not illustrated in Figure 17).

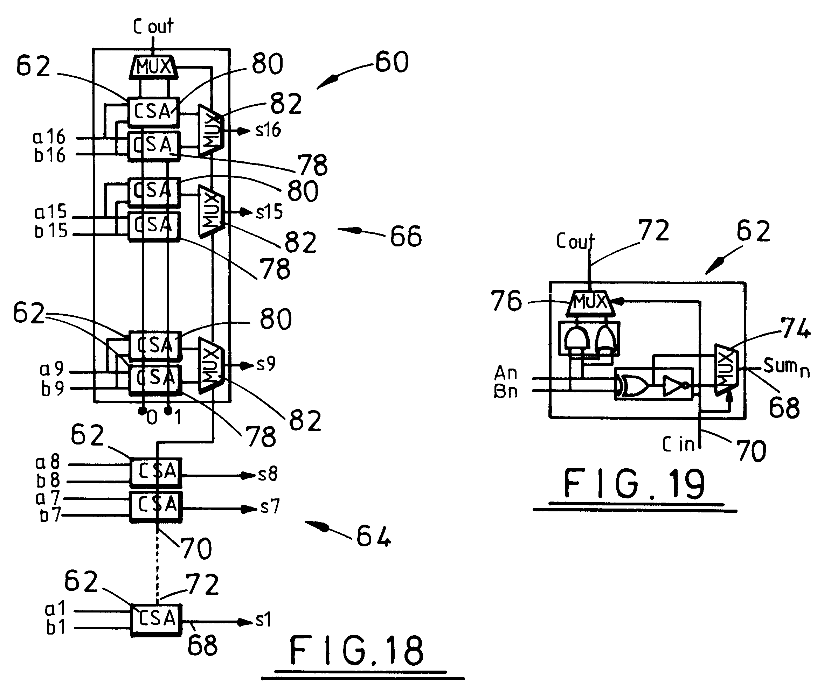

A novel adder structure which can be configured by the device will now be described with reference to Figures 18 to 21. A 16-bit adder is illustrated in Figure 18 and indicated generally by numeral 60. The adder comprises a plurality of carry select adders 62 forming a first multi-bit adder block 64 and a second multi-bit adder block 66. The adder 60 sums two 16 bit words indicated as a1, a2, a3.....a16 and b1, b2, b3.....b16 in order to derive a sum indicated by s1, s2, s3.....s16 and carry element 'Cout'.

First multi-bit adder block 64 sums the eight least significant bits of each 16 bit word and for each bit there is an associated carry select adder 62. Each carry select adder comprises two inputs An, Bn (wherein 'n' is the number of the bit), output 68, carry in 70, carry out 72 and a first and second 2:1 multiplexer 74, 76. The first input to the first multiplexer 74 is equal to the value of An + Bn assuming the carry in is '0' and the second input assumes that carry in to be '1'. The output Sn is selected by the carry in 70.

The two inputs to the second multiplexer 76 are equal to the carry resulting from the sum of An and Bn with the carry in being equal to '0' and '1'. The carry out 72 is selected by carry in 70. Obviously, the carry in to the first carry select adder will be equal to '0'.

The second multi-bit adder block 66 sums the eight most significant bits of each 16 bit word and for each bit there are two associated carry select adders, 78, 80. Each of the carry select adders 78, 80 is constructed in a similar manner as described above. Carry select adders 78 sum the two eight bit words ie. a₉, a₁0.....a₁6 and b₉, b₁0.....b₁6, assuming that the carry out from the first adder block 64 is '1' and carry select adders 80 assume that the carry out is '0'. Therefore, for each bit two outputs are calculated and fed into an associated multiplexer 82. The output providing Sn is selected by the carry out from the first adder block 64.

In operation, the first adder block calculates the addition of the eight least significant bits and produces a carry out value. Simultaneously, the second adder block calculates the two possible sums of the addition of the most significant bits and the correct sum is selected by the carry out produced by adder block 64. In consequence the time delay to calculate a 16 bit addition is taken to be the delay in the addition of the first eight bits (8ADD) plus the delay in selecting the sum of the last eight bit ie. one multiplexer delay (MUX).

For each additional eight bit adder block the time delay is equal to one multiplexer. For example, a thirty two bit adder would result in a propagation delay of 8ADD + 3 X MUX. In consequence, the adder structure described results in an improved speed of operation compared to that of a conventional adder structure.

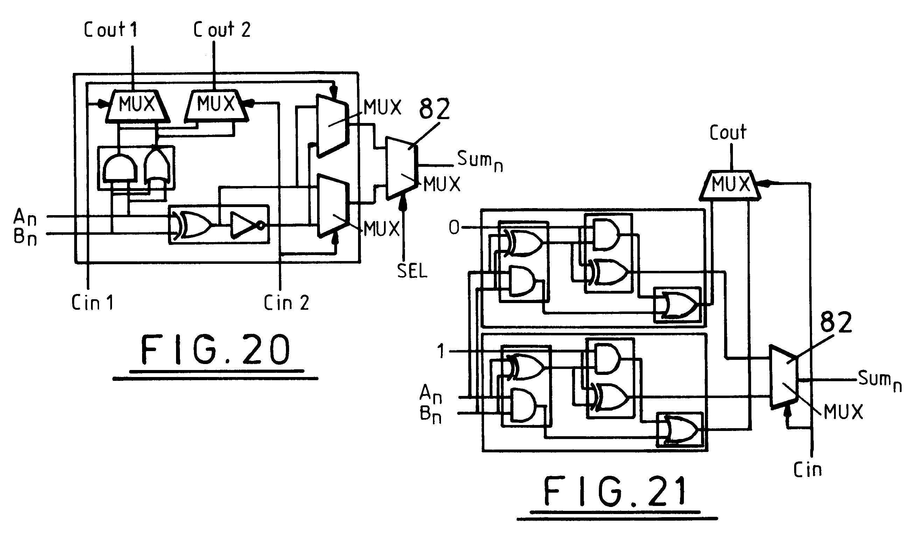

Figure 20 illustrates an alternative cell structure wherein the two carry select adder requiring two cells can be replaced by a single configured cell.

Figure 21 illustrates a conventional circuit for single stage carry select adder which may be used as an alternative to the circuit of Figure 19.

The operation of the device will now be described wherein initially, as described above, the configuration provisions 40 are 'hard wired' or fixed with a DSP configuration 40a and a multipler configuration 40b.

An external memory store (not shown) contains all the necessary configuration data in order to control the controller and sequencer such that each of the data stores (36a-d, 38) in each cell can be programmed. In order to program a data store a typical procedure would be to firstly select the cell by memory select 45, select the data store to be write enabled by instruction update bus 44 and to write data to the selected store via data bus 46.

Each of the four data stores of the configuration cache 36 contains sufficient configuration data to select the input to the logic cell 22 and to also select one of the functions contained within the logic cell.

The initial boot up operation of the device results in a configuration as per either of the primary configurations 40a, 40b according to the boot up instruction. Thus for example the DSP or Multiplier configuration is established.

However, if the device is required to implement another configuration eg. a divide function, then the controller and sequencer 5 selects and write enables the required data store of the configuration cache 36 of each cell necessary to implement the configuration. The external memory supplies the necessary data as to which cell and data stores are to be selected in order to implement the required configuration.

There is also the option for adopting other programmed configurations from the configuration cache and for writing and substituting other configurations.

Thus for the example given, the four configurations possible from the configuration cache may not be sufficient. Software programming can be used to implement another configuration. The programmer will be able to refer to the technical specifications for the device and determine how the desired function/configuration can be implemented (for example many possible architecture changes will be listed, perhaps in terms of a load instruction). Thus whilst load instructions 1-4 might represent the most typical configurations which are to be stored in the configuration cache, the programmer determines from the technical specification that load instruction 33 for example is required. Thus the programmer will have the instruction loaded into the configuration cache. There will be instances where more configurations are required to process the incoming data then can be stored in the cell memory for access at clock speed. However, this difficulty can be overcome by re-programming a "redundant" configuration cache with the "additional" configuration data in advance of its requirement, by including the re-configuration instruction in the software programme. The sequencer can control re-configuration at clock speed, whilst the data from the configuration is held safe in the latch cells. The four configurations (36a-36d) of the cache can be reused in different combinations at different cell sites. This is facilitated by instruction cache (38) which can select different local cell configurations from a global instruction placed on instruction bus 42.

## Claims

1. A configurable semi-conductor integrated circuit in which an area (1) thereof is formed with a plurality of cells (2) each having at least one function and inter-connections with at least some other said cells (2), characterised in that at least some of the plurality of cells (2) have interconnections (25) which are electrically selectable as to their conduction state, and at least some of the plurality of cells (2) have interconnections (YA-YD) which are pre-wired, each cell has two or more possible configurations, each configuration being defined by the cell function and/or its interconnection with other cells according to cell configuration data, and further comprising means (36, 38, 40) storing configuration data for at least two cell configurations (per cell) and means (30, 32, 34, 42, 48) to enable one of the possible cell configurations according to the cell configuration data selected.

2. A configurable semi-conductor integrated circuit as claimed in claim 1 in which means (36, 38, 40) storing at least two cell configurations are present in the cell.

3. An integrated circuit as claimed in claim 1 or 2 in which the means for selecting the required cell configuration comprises an instruction bus (42) communicating with the said configuration data store.

4. An integrated circuit as claimed in claim 1, 2 or 3 in which at least one of the cell configurations is pre-wired (40a, 40b) to configure the integrated circuit with an application specific function when selected.

5. An integrated circuit as claimed in claim 4 in which there are two pre-wired (40a, 40b) application specific functions.

6. An integrated circuit as claimed in any one of the preceding claims in which there is at least one programmable cell configuration.

7. An integrated circuit as claimed in any one of the preceding claims in which there are both pre-wired and programmable cell configurations.

8. An integrated circuit as claimed in claim 6 or 7 further comprising a write enable bus (44), and a data bus (46) communicating with the means (36, 38) storing the cell configuration data for the purpose of rewriting data to the store for re-programming purposes.

9. An integrated circuit as claimed in any one of the preceding claims further comprising means storing a plurality of configuration selection instructions, an instructions select bus (42) communicating with said means and an output signal path for selecting the required configuration data store to be implemented or directly effecting cell configuration.

10. An integrated circuit as claimed in claim 9 further comprising an instruction write bus (44) and an instruction data bus (46) for writing to the instruction storing means (36, 38).

11. An integrated circuit as claimed in any one of the preceding claims in which means (54) is provided to preserve the output between configurations.

12. An integrated circuity as claimed in claim 11 in which said means comprises a latch (54) wherein each cell incorporates a latch to preserve its output.

13. An integrated circuit as claimed in any one of the preceding claims in which the cells are optimised for a primary function.

14. An integrated circuit as claimed in claim 13 comprising cells which are optimised for different primary functions.

15. An integrated circuit as claimed in any one of the preceding claims including means (60) to reduce transient current when switching between configurations.

16. An integrated circuit as claimed in claim 15 in which said means comprises a controllable buffer (60) in the output line of each cell.

17. An integrated circuit as claimed in any one of the preceding claims further comprising sequencer means (5) to control the availability and selection of the configuration.

18. An integrated circuit as claimed in any one of the preceding claims comprising decode means (30, 32, 34, 48) in each cell (2) to decode configuration state to control the configuration of each cell.

19. An integrated circuit as claimed in any one of claims 4 or 5, 13 or 14 in which the configuration data store corresponding to the primary or application specific function of the cell is contained within the device in a non-volatile memory.

20. An integrated circuit as claimed in any one of claims 13 or 14 in which the pre-wired (hidden) interconnect resources interconnect optimised cells for efficient implementation of the primary (application specific) functions.

21. A multi-bit adder for summing at least two multi-bit words comprising a first multi-bit adder block (64) for summing the least significant bits and at least one further multi-bit adder block (66) for summing the most significant bits and having sum selection means wherein said further multi-bit adder block calculates the two possible sums resulting from a carry out from the previous block being equal to 'O' and '1' respectively and wherein the sum selection means selects the sum of the further multi-bit adder block according to the carry out calculated from the previous block.

22. A method of configuring a configurable semi-conductor integrated circuit having a plurality of cells (2) with at least two configuration possibilities in which a sequencer (5) is programmed with data to facilitate selection of the required cell configuration.

23. A method as claimed in claim 22 further comprising inputting and storing cell configuration data.

24. A method as claimed in claim 22 or 23 further comprising programming the sequencer with data to write over previously stored configuration data at a prescribed point in operation of the circuit.

25. A configurable semi-conductor integrated circuit characterised in that circuit configuration is changed according to a pre-programmed sequence of configurations during operation of the device.

26. An integrated circuit as claimed in claim 25 in which an area there is formed with a plurality of cells, each cell having two or more possible configurations, each configuration being defined by the cell function and for its interconnection with other cells according to configuration data.
